# DEMANDE DE BREVET EUROPEEN

(11) **EP 4 060 399 A1**
(43) Date de publication de la demande: **21.09.2022**
(21) Numéro de dépôt: 22154701.1
(22) Date de dépôt: 02.02.2022
(51) Int. Cl.: G02F 1/13, G02F 1/1333, G02F 1/1362

(54) **CARACTÉRISATION ÉLECTRIQUE DE CIRCUIT D'ADRESSAGE MATRICIEL**

(30) Priorité: 16.03.2021 FR 2102571
(71) Demandeur: Commissariat à l'énergie atomique et aux énergies alternatives, 75015 Paris (FR)
(72) Inventeur: SUHM, Aurélien, 38054 GRENOBLE CEDEX 09 (FR); LE RHUN, Gwenaël, 38054 GRENOBLE CEDEX 09 (FR); DEVANCIARD, Nicolas, 38054 GRENOBLE CEDEX 09 (FR)
(74) Mandataire: Brevalex

(57) **Abrégé**

Structure (10) pour le test d'un circuit électronique (50) d'adressage d'une matrice de cellules comprenant :
- une pluralité de blocs (15₁,...,15ₘ) à base d'au moins un premier matériau (14), piézo-électrique et/ou diélectrique dont les propriétés diélectriques sont modulables en fonction de l'intensité d'un champ électrique qui lui est appliqué,
- au moins une région de séparation entre lesdits blocs (15), la structure (10) comprenant en outre :
- une électrode (18) commune connectée à une première extrémité (15A) desdits blocs (15₁,...,15ₘ) à base dudit premier matériau (14), une deuxième extrémité desdits blocs (15₁,...,15ₘ) à base dudit premier matériau (14) étant agencée par rapport à une face (10B) de la structure (10) appelée « face de contact », de sorte que lorsque la face (10B) de contact est disposée sur le circuit d'adressage, la deuxième extrémité (15B) desdits blocs (15₁,...,15ₘ) est connectée à au moins un plot conducteur du circuit d'adressage.

## Description

### DOMAINE TECHNIQUE

La présente invention se situe dans le domaine du test électrique pour vérifier la fonctionnalité et/ou caractériser un circuit électronique de commande, également appelés circuit « d'adressage », des cellules d'une matrice de cellules et s'applique notamment au test de circuits d'adressage de matrices, comme les micro-écrans, dont les cellules sont des pixels ou des éléments afficheurs par exemple de type à cristaux liquides ou LED (« light-emitting diode ») en matériau organique ou en matériau III-N.

Elle concerne en particulier une structure améliorée pour permettre de tester la fonctionnalité des éléments d'un circuit électronique d'adressage matriciel ainsi qu'un dispositif de test muni d'une telle structure et ce, avant même l'assemblage complet de la matrice.

### ÉTAT DE LA TECHNIQUE ANTÉRIEURE

Les dispositifs d'affichage de type micro-écrans sont généralement formés d'une matrice de pixels afficheurs agencée et assemblée sur un circuit électronique d'adressage des pixels, typiquement sous forme d'un ASIC (acronyme de « Application-Specific Integrated Circuit », i.e. « circuit intégré propre à une application »), permettant de moduler, en fonction de la technologie utilisée, la tension et/ou le courant des pixels.

Des dispositifs de test électrique permettant de valider le fonctionnement de tels afficheurs, déterminer leurs caractéristiques, voire d'effectuer une calibration existent.

Le document US5546013A présente par exemple un dispositif de test d'une matrice de pixels LCD (Liquid Crystal Display, soit « affichage à cristaux liquides) commandés par des transistors TFT (« Thin-Film Transistor »). Le test est ici effectué en émettant des impulsions électriques de test sur des lignes de grille et des lignes de données auxquelles la matrice est reliée.

Le document US10580352 B2 prévoit un dispositif de test d'une matrice de micro-diodes électroluminescentes à l'aide de sondes et prévoit notamment d'analyser une image émise par la matrice pour vérifier sa fonctionnalité.

Le document US10198984 B2 concerne, quant à lui, un dispositif de test permettant de déterminer et calibrer la luminance des pixels d'un dispositif d'affichage.

D'une manière générale, lorsque l'on réalise le test de ce type de dispositif il peut être dans certains cas difficile de conclure avec certitude quelle partie du dispositif est à l'origine d'un dysfonctionnement, et en particulier si ce dysfonctionnement provient de la matrice de pixels en elle-même ou bien du circuit d'adressage qui permet de commander individuellement les pixels de cette matrice.

Pour permettre de vérifier un éventuel défaut qui serait lié au procédé de fabrication du circuit d'adressage, il est connu d'ajouter des motifs de test au plus proche du circuit d'adressage afin de valider que sa fabrication s'est bien déroulée.

Néanmoins cela ne reflète que partiellement le fonctionnement électrique final de chaque pixel ou élément de commande associé du dispositif d'affichage.

Il se pose ainsi le problème de trouver un nouveau dispositif de test de fonctionnalité des éléments d'un circuit d'adressage d'une matrice de cellules et qui soit en particulier amélioré vis-à-vis d'inconvénient(s) mentionné(s) ci-dessus.

### EXPOSÉ DE L'INVENTION

Selon un aspect, la présente invention concerne une structure pour le test d'un circuit électronique d'adressage d'une matrice de cellules, ledit circuit électronique d'adressage étant destiné à être assemblé avec et connecté à ladite matrice ou au moins une couche de ladite matrice par l'intermédiaire de plots conducteurs, ladite structure comprenant :
- une pluralité de blocs à base d'au moins un premier matériau, piézo-électrique et/ou diélectrique dont les propriétés diélectriques sont modulables en fonction de l'intensité d'un champ électrique qui lui est appliqué,
- au moins une région de séparation entre lesdits blocs, ladite au moins une région de séparation étant à base d'au moins un matériau isolant, ladite structure de test comprenant en outre :
- une électrode commune connectée à une première extrémité desdits blocs à base dudit premier matériau,
une deuxième extrémité desdits blocs à base dudit premier matériau aboutissant au niveau d'une face de contact de ladite structure ou d'une zone conductrice aboutissant au niveau de ladite face de contact de sorte que, lorsque ladite face de contact de la structure est disposée de manière amovible sur le circuit d'adressage, une deuxième extrémité desdits blocs peut être connectée à au moins un plot conducteur donné parmi lesdits plots conducteurs.

Une telle structure peut permettre de réaliser des tests et/ou des mesures sur un circuit d'adressage avant que la matrice de cellules ne soit rapportée ou qu'une couche, par exemple une couche d'affichage ayant des propriétés électroluminescentes ne soit rapportée sur le circuit d'adressage.

Par « cellule », on entend ici un élément ou une zone d'une matrice qui peut être commandé(e) individuellement. Le terme cellule ne désigne ainsi pas uniquement un pixel doté d'un élément afficheur. En effet, la matrice peut en variante être formée de cellules chacune dotée d'un élément détecteur, ou capteur, ou transducteur, ou émetteur, ou actionneur.

Un test est typiquement réalisé en appliquant au moins un signal électrique de test et en détectant et/ou en mesurant, consécutivement à un tel signal d'éventuelles variations, en particulier de forme et/ou de propriétés diélectriques des blocs de la structure dues à une variation d'un champ électrique entre au moins un plot conducteur et l'électrode commune.

Selon une possibilité de mise en œuvre, l'électrode commune peut reposer sur un substrat.

Le substrat peut être avantageusement en matériau polymère ou en caoutchouc ou en verre.

Le substrat peut être en particulier un substrat souple de par son épaisseur et le ou les matériaux le constituant. Le substrat peut être prévu en un matériau tel que le substrat a un rapport densité volumique de masse sur module d'Young (d/E) supérieur à 100 s²m⁻², en particulier en matériau polymère ou en caoutchouc.

Avantageusement, l'électrode commune repose sur un substrat à base de matériau transparent aux rayons lumineux, en particulier dans le domaine du visible et/ou de l'infrarouge.

De manière avantageuse, l'électrode commune peut être formée d'une couche conductrice transparente aux rayons lumineux en particulier dans le domaine du visible et/ou de l'infrarouge.

Selon une possibilité de mise en œuvre de la structure, ladite première extrémité desdits blocs à base dudit premier matériau peut être revêtue d'une zone conductrice et réfléchissante des rayons lumineux en particulier dans le domaine du visible et/ou de l'infrarouge.

Avantageusement, le deuxième matériau de la ou les régions de séparation peut être à base de matériau polymère et/ou prévu avec un module d'Young inférieur à 50 GPa.

Selon un autre aspect, la présente invention concerne un dispositif de test d'un circuit électronique d'adressage comprenant une structure telle que définie plus haut connectée et disposée de manière amovible sur le circuit d'adressage. Par « de manière amovible » on entend que la structure peut être retirée du circuit d'adressage une fois le test ou la ou les mesures effectué(e)s, et en particulier par simple préhension sans qu'un autre traitement ne soit nécessaire pour réaliser ce retrait.

Ainsi, un mode de réalisation de la présente invention concerne un dispositif de test d'un circuit électronique d'adressage d'une matrice de cellules, chaque cellule comprenant un élément apte à être commandé par le biais d'un élément de commande dudit circuit électronique d'adressage, ledit circuit électronique d'adressage comprenant un ensemble matriciel d'éléments de commande et étant pourvu d'un premier agencement matriciel de plots conducteurs, chaque élément de commande étant doté d'au moins un desdits plot conducteurs, le dispositif de test comprenant :
- une structure telle que définie précédemment, agencée, ladite structure étant agencée de manière amovible sur ledit circuit d'adressage et de sorte qu'au moins un premier plot conducteur dudit premier ensemble matriciel de plots conducteurs est connecté à un ou plusieurs blocs à base du premier matériau de ladite structure, et de sorte qu'au moins un deuxième plot conducteur dudit premier ensemble matriciel de plots conducteurs est connecté à un ou plusieurs autres blocs à base du premier matériau de ladite structure.

A l'échelle d'un élément de commande encore appelé « sous-cellule » ou « sous-pixel » du circuit d'adressage, on peut tester ou mesurer une grandeur physique permettant de contrôler l'adressage de la cellule. Un tel dispositif permet d'obtenir une cartographie du fonctionnement du circuit d'adressage et ce avant la réalisation d'étapes technologiques permettant de finaliser la matrice.

Avantageusement, dans ledit premier ensemble matriciel, lesdits plots conducteurs du circuit d'adressage sont répartis selon un premier pas de répartition et dans lequel les blocs à base dudit premier matériau sont répartis selon un deuxième ensemble matriciel avec un deuxième pas de répartition, le deuxième pas de répartition étant prévu supérieur au premier pas de répartition et de sorte que chaque plot conducteur est connecté à au moins un bloc à base du premier matériau de ladite structure de test. Un tel agencement peut permettre une disposition de la structure de test sans nécessairement devoir réaliser un alignement précis des blocs de la structure de test par rapport auxdits plots dudit premier ensemble matriciel.

Le dispositif de test peut comprendre en outre un circuit générateur de signaux électriques de test.

Ce circuit générateur peut être connecté à l'électrode commune de la structure et configuré pour appliquer un ou plusieurs signaux électriques de test aux éléments de commande dudit circuit d'adressage.

Lorsque le premier matériau dans la structure est piézoélectrique, le dispositif peut comprendre en outre un dispositif de mesure configuré pour détecter une déformation de ladite structure consécutive à une application d'au moins un premier signal électrique de test à un premier élément de commande.

Le dispositif de mesure peut être doté moyens de mesure optiques, par exemple comprenant un profilomètre optique plein champs et/ou au moins une caméra.

En variante ou en combinaison, le dispositif de test peut également comprendre un dispositif de mesure électrique connecté à l'électrode commune et à au moins un premier plot, et configuré pour mesurer un signal électrique de réponse à au moins un premier signal électrique de test appliqué à un premier élément de commande relié au premier plot.

On peut changer de plot testé en changeant de plot sélectionné par le biais du circuit d'adressage.

Ce dispositif de mesure électrique peut être en particulier doté d'un capacimètre configuré pour, consécutivement à l'application du premier signal électrique de test mesurer une capacité entre ledit premier plot et ladite électrode commune.

Ce dispositif de mesure électrique peut être également doté d'un moyen de mesure de courant entre ledit premier plot et ladite électrode consécutif à l'application du premier signal électrique de test.

Selon une possibilité de mise en œuvre du dispositif de test, le circuit générateur de signaux de test peut être configuré pour :
- appliquer un premier potentiel à un premier élément de commande du circuit d'adressage, puis appliquer un autre potentiel différent du premier potentiel au premier élément de commande, et/ou pour,
- appliquer un premier potentiel à un premier élément de commande du circuit d'adressage et appliquer un deuxième potentiel à un deuxième élément de commande du circuit d'adressage.

Selon un mode de réalisation particulier, le circuit électronique d'adressage peut être dédié à la commande d'une matrice d'éléments afficheurs, par exemple de type LCD ou de type LEDs organiques ou micro-LEDs, en particulier en matériau III-N tel que du GaN.

Selon un autre aspect, la présente demande concerne un procédé de test électrique et/ou de mesure comprenant l'utilisation d'un dispositif de test tel que défini plus haut.

Selon un autre aspect, la présente demande concerne un procédé de fabrication d'un dispositif matriciel doté d'une matrice de pixels, chaque pixel étant apte à être commandé par le biais d'un élément de commande d'un circuit électronique d'adressage, le procédé comprenant, dans cet ordre, des étapes consistant à :
- mettre en place un dispositif de test tel que défini plus haut, afin de tester le circuit d'adressage,
- retirer ladite structure de test dudit circuit d'adressage, puis
- assembler et connecter sur ledit circuit d'adressage ladite matrice de pixels ou au moins une couche dudit dispositif matriciel, en particulier une couche d'affichage.

Ainsi, lors d'un procédé de fabrication d'un micro-écran commandé par un circuit d'adressage de type ASIC, après avoir fabriqué l'ASIC on teste cet ASIC au moyen d'une structure et d'un dispositif tels que définis plus haut, puis on peut assembler sur cet ASIC une ou plusieurs couches électro-optiques pixellisées ou non.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 sert à illustrer un exemple de structure telle que mise en œuvre suivant un mode de réalisation de la présente invention et destinée à être disposée de manière amovible sur un circuit électronique matriciel d'adressage dédié à la commande de pixels d'une matrice ;
La figure 2 sert à illustrer un exemple de dispositif de test tel que mis en œuvre suivant un mode de réalisation de la présente invention dans lequel la structure de test est agencée de manière temporaire sur le circuit d'adressage avant son assemblage final avec une matrice de pixels ou avec au moins une couche d'affichage ;
La figure 3 sert à illustrer un exemple de dispositif de test d'éléments de commande d'un circuit électronique matriciel associé à un dispositif optique de détection des déformations de blocs de matériau piézoélectrique disposés sur le circuit d'adressage et aux extrémités desquels une tension électrique de test est susceptible d'être appliquée ;
Les figures 4A, 4B servent à illustrer un schéma électrique équivalent d'un élément de commande d'un exemple particulier de circuit d'adressage d'un afficheur à cristaux liquides et un schéma électrique équivalent de ce même élément de commande lorsqu'elle est associée à une structure de test telle que mise en œuvre suivant un mode de réalisation de la présente invention ;
Les figures 5 et 6 servent à illustrer une variation de capacité de blocs diélectrique d'une structure de test lorsqu'on leur applique différentes tensions de test ;
La figure 7 sert à illustrer un mode de réalisation pour lequel le test du circuit d'adressage est réalisé par détection d'une variation de capacité de blocs de la structure de test en matériau diélectrique de constante diélectrique modulable ;
La figure 8 sert à illustrer un étage d'un circuit, générateur de signaux de test, configuré pour émettre des signaux électriques de test aux différents éléments de commande d'un circuit d'adressage, et qui est co-intégré dans un même circuit que le circuit d'adressage ;
La figure 9 sert à illustrer un assemblage entre une matrice d'éléments d'affichage et son circuit d'adressage une fois un test de fonctionnalité et/ou des mesures telles que mis en œuvre suivant l'invention ont été effectuées sur le circuit d'adressage ;
Les figures 10A, 10B, 10C, 10D, 10E, 10F, 10G, 10H servent à illustrer un exemple de procédé de fabrication d'une structure de test telle que mise en œuvre suivant un mode de réalisation de la présente invention.

Des parties identiques, similaires ou équivalentes des différentes figures portent les mêmes références numériques de façon à faciliter le passage d'une figure à l'autre.

### EXPOSÉ DÉTAILLÉ DE MODES DE RÉALISATION PARTICULIERS

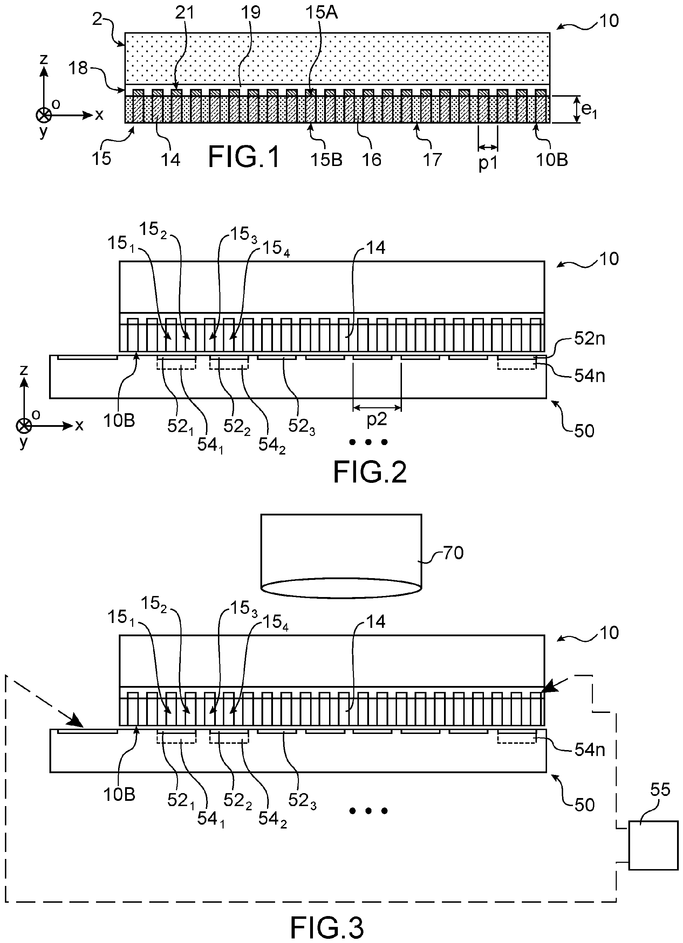

On se réfère à présent à la figure 1 donnant un exemple de réalisation d'une structure 10 suivant l'invention, pour réaliser un test d'un circuit électronique matriciel d'adressage (non représenté sur cette figure).

Le circuit électronique à tester, et dont on souhaite vérifier la fonctionnalité et/ou mesurer certains paramètres de fonctionnement, permet de réaliser l'adressage autrement dit de commander et/ou activer individuellement des éléments encore appelés « cellules » d'une matrice.

Les cellules de cette matrice peuvent être par exemple des éléments afficheurs, autrement dit des pixels d'affichage, tels que par exemple des LEDs organiques ou en matériau III-N ou des afficheurs à cristaux liquides. Dans ce cas, la matrice d'éléments afficheurs ou au moins un couche d'affichage électro-optique sont destinés à être assemblés ultérieurement sur le circuit d'adressage, en particulier une fois que la fonctionnalité de ce circuit d'adressage est vérifiée.

La structure 10 de test est ainsi prévue amovible et amenée à être disposée de manière temporaire sur le circuit d'adressage pour réaliser un test d'éléments de commande de ce dernier encore appelés « sous-cellules », chaque élément de commande (ou sous-cellule) étant associé à une cellule et prévu(e) pour commander et/ou activer cette cellule. Dans le cas où les cellules sont des pixels afficheurs, chaque pixel est typiquement associé à plusieurs sous-cellules (dans ce cas appelés « sous-pixels »), chacune permettant de contrôler l'affichage d'une couleur. La structure 10 permet alors de vérifier le fonctionnement à l'échelle des sous-pixels.

Pour tester le circuit d'adressage et en particulier vérifier la fonctionnalité de ses éléments de commande (ou sous-cellules) on intègre à la structure 10 des blocs 15 d'un matériau piézo-électrique et/ou diélectrique.

Le matériau des blocs 15 est un matériau choisi de sorte que ses propriétés peuvent être modulées en fonction de l'intensité d'un champ électrique de test qu'on lui applique. Dans le cas où les blocs 15 sont en matériau diélectrique, on choisit un matériau dont les propriétés diélectriques, en particulier la constante diélectrique, peuvent varier en fonction de l'amplitude d'un champ électrique qui lui est appliqué.

Dans le cas où les blocs 15 sont en matériau piézo-électrique, ils peuvent être en particulier à base de matériau ferroélectrique ou pyroélectrique.

La figure 1 sert à illustrer un exemple de réalisation particulier pour lequel les blocs 15 sont en matériau piézoélectrique 14. Les blocs 15 sont dans ce cas aptes à se déformer lorsqu'on leur applique un champ électrique adéquat. La structure de test 10 est ainsi pourvue d'une pluralité de blocs 15 distincts, chaque bloc pouvant être amené à être déformé lorsqu'on lui applique un signal de test électrique, typiquement une tension par le biais d'électrodes agencées de part et d'autre de ce bloc 15.

Les blocs 15 de matériau piézoélectrique 14 ont une épaisseur e₁ (mesurée parallèlement à l'axe z d'un repère orthogonal [O ;x ;y ;z] donné sur la figure 1) qui peut être de l'ordre de plusieurs micromètres ou inférieure, par exemple comprise entre 50 nm et 1 µm. On choisit typiquement cette épaisseur e₁ en établissant un compromis entre un niveau de coefficient piézoélectrique d33,f communément appelé « d33 » requis, qui augmente en fonction de l'épaisseur du bloc 15, et un niveau de champ électrique que l'on souhaite appliquer à ce bloc 15 et qui diminue avec l'épaisseur.

Les dimensions latérales (dimensions mesurées parallèlement au plan [O ;x ;y ]) des blocs 15 de piézoélectrique 14 sont choisies quant à elles en prenant en compte de la résolution des plots conducteurs du circuit à tester et auxquels ils sont destinés à être connectés. Les blocs 15 de piézoélectrique 14 peuvent avoir par exemple une largeur comprise entre 0.5 et 1 µm.

Les blocs 15 sont typiquement répartis selon un agencement matriciel, en au moins une rangée et typiquement en plusieurs rangées de blocs 15 distincts. L'agencement matriciel est dans ce cas de préférence prévu en fonction de celui de plots conducteurs du circuit d'adressage sur lequel les blocs 15 de matériau piézoélectrique 14 sont amenés à être disposés. On choisit de préférence un pas p₁ (distance mesurée parallèlement au plan [O ;x ;y] et donnée sur la figure 1) de répartition des blocs 15 de matériau piézoélectrique inférieur à celui p₂ de plots conducteurs du circuit électronique à tester. Le pas p₁ ici défini comme la distance cumulée de la largeur d'un bloc et de la région séparant deux blocs 15 de matériau piézoélectrique 14 adjacents est inférieure à la distance cumulée entre la largeur d'un plot et la largeur d'une zone séparant deux plots conducteurs adjacents, de sorte que lorsqu'on dispose la structure 10 contre l'agencement matriciel de plots conducteurs, un plot conducteur du circuit électronique à tester est disposé en regard et en contact d'au moins un bloc 15 de matériau piézoélectrique. De préférence, on choisit p₁ de l'ordre de 3 à 4 fois plus faible que p₂ (distance mesurée parallèlement au plan [O ;x ;y] sur les figures 1 et 2). La distance entre deux blocs 15 de matériau piézoélectrique adjacents peut être également choisie en fonction de la résolution dans le plan minimale des objectifs utilisés, par exemple sur un profilomètre optique, amené à mesurer une déformation du matériau piézoélectrique 14 lorsqu'on lui applique un signal électrique de test. Ce choix dépend également du paramètre d₃₃ du matériau piézoélectrique 14. Par exemple, on peut prévoir une distance entre blocs 15 adjacents de matériau piézoélectrique entre 0.3µm et 3.5µm. Une dimension latérale submicronique des blocs 15 a pour avantage d'augmenter le coefficient piézoélectrique d₃₃ du fait de la mobilité accrue des domaines a, correspondant à une polarisation dans le plan par rapport au domaine c correspondant à une polarisation hors plan.

Le matériau piézoélectrique 14 est de préférence choisi de manière à présenter un coefficient piézoélectrique d₃₃ important, c'est à dire supérieur à 50 pm/V.

Le matériau piézoélectrique 14 peut être en particulier un ferroélectrique par exemple tel que du titano-zirconate de plomb (PZT), ou du PZT dopé au Lanthane (La) ou au Niobium (Nb), ou du PMN-PT (niobate-titanate de plomb-magnésium), ou un matériau céramique piézoélectrique tel que du KNN (Sodium Niobate de Potassium), ou un matériau à base de bismuth comme le (BiₓNa_{y})TiO₃, avec typiquement x=y=0.5 connu sous l'acronyme BNT, ou bien du BNT-BT (1-x)(Bi_{0.5}Na_{0.5})TiO₃-xBaTiO₃ avec x typiquement entre 0.05 et 0.1. Le matériau piézoélectrique 14 peut être également un matériau pyroélectrique tel que par exemple de l'AIN ou du ZnO. En adaptant la composition du matériau piézoélectrique 14 on peut augmenter, si nécessaire, le coefficient piézoélectrique d33. Cela peut être réalisé notamment en optimisant le ratio entre les domaines a et c ou bien en prévoyant un matériau piézoélectrique 14 poreux, par exemple du PZT poreux.

Entre les blocs 15 de matériau piézoélectrique adjacents on prévoit typiquement au moins un espace ou une région 17 de séparation en un matériau 16 différent de celui des blocs 15, afin de favoriser une déformation individuelle de ces derniers. Le matériau 16 des régions 17 est de préférence isolant. Le matériau 16 de la ou des régions 17 de séparation est choisi de préférence avec un module d'Young faible, qui peut être inférieur à 100 GPa et en particulier à 50 GPa, de préférence inférieur à 10 GPa afin de ne pas perturber la déformation des blocs 15 de matériau piézoélectrique 14. Avantageusement, on choisit un matériau 16 à base de polymère, en particulier un polymère isolant, par exemple tel que du Fujifilm LTC série 9300, ou du TOK TELR. On peut également prévoir des régions 17 en polymère photosensible par exemple une résine de type série S1800 ou des films secs photosensibles de type WBR 2000^{™}.

Lors d'un test, on peut être amené à appliquer un champ électrique à un ou plusieurs bloc(s) 15 donné(s) à base de matériau piézoélectrique 14, entre une électrode 18 commune appartenant à la structure 10 et prévue à une première extrémité 15A des blocs 15 et au moins un plot conducteur (non représenté sur cette figure) du circuit d'adressage agencé du côté d'une deuxième extrémité 15B du ou des blocs 15 donnés de matériau piézoélectrique 14, opposée à la première extrémité 15A.

Dans l'exemple de réalisation particulier illustré, la deuxième extrémité 15B desdits blocs 15 aboutit au niveau d'une face 10B dite « de contact » contre laquelle le circuit à tester est amené à être disposé. Un tel agencement permet de placer directement en contact un ou plusieurs blocs 15 avec un plot conducteur du circuit à tester et de réaliser un contact électrique direct avec ce plot. Selon une variante (non représentée), on peut prévoir de revêtir la deuxième extrémité 15B des blocs 15 de zones conductrices débouchant sur ladite face de contact.

L'électrode 18 commune de la structure 10 de test est ici formée d'au moins une couche conductrice 19 agencée sur et en contact avec les blocs 15 de matériau piézoélectrique 14. Selon un exemple de réalisation particulier, la couche conductrice 19 peut être sous forme d'un film conducteur transparent par exemple à base d'un oxyde conducteur transparent (TCO) tel que de l'Oxyde d'indium-étain (ITO), en particulier lorsque l'on souhaite détecter la déformation de blocs 15 par le biais d'un dispositif optique. Un oxyde de Zinc (ZnO) pur, ou dopé, en particulier à l'aide d'un des éléments suivants : Al, In, Sn, B, Ga, peut être également utilisé. Un oxyde d'étain (SnO₂) pur ou dopé, ou un oxyde d'indium (In₂O₃ :H) peuvent être également employés.

La couche conductrice 19 repose ici sur un substrat 2, de préférence un substrat souple, autrement dit dont l'épaisseur et la composition, typiquement en matériau polymère, lui permettent de s'adapter à une déformation des blocs 15 de matériau piézoélectrique 14. Le matériau du substrat 2 peut être en particulier en un matériau polymère identique à celui utilisé pour réaliser les régions 17 de séparation. Le substrat 2 peut être par exemple un polymère de type poly(téréphtalate d'éthylène) (PET).

On choisit de préférence un matériau ayant une déformation importante sous la force gravitationnelle de son propre poids. Le matériau est ainsi choisi avec un rapport densité volumique de masse sur module d'Young (d/E) élevée de préférence le plus élevé possible et supérieure à 100 s²m⁻², typiquement dans une gamme comprise entre 100 s²m⁻² et 10⁵ s²m⁻². Un matériau polymère organique tel que le PS, le PET, le PMMA et encore plus avantageusement le caoutchouc, peut être utilisé, ainsi que ceux utilisés habituellement pour mettre en œuvre des moulages.

De même, on peut prévoir avantageusement le substrat 2 en un matériau transparent et en particulier transparent dans le domaine de longueurs d'ondes auquel fonctionne un dispositif optique permettant de détecter une déformation des blocs 15. Ce dispositif optique peut être par exemple doté d'un interféromètre (non représenté) optique plein champs fonctionnant par exemple dans le domaine du visible ou infrarouge. L'appareillage est associé à une source lumineuse ou laser qui émet un rayonnement incident sur ladite structure 10 et permet ainsi l'analyse de sa surface.

Avantageusement, on peut également prévoir de revêtir les blocs 15 de matériau piézoélectrique 14 d'une zone 21 réflectrice de rayonnement lumineux, en particulier dans le domaine de longueurs d'ondes dans lequel fonctionne le dispositif optique précité, par exemple du visible et/ou de l'infrarouge. Cela permet d'améliorer la détection de déformation en augmentant le contraste de la mesure. La zone 21 réflectrice agencée à l'extrémité d'un bloc 25 peut être formée d'un métal, par exemple choisi parmi les suivants : Platine (Pt), Ruthénium (Ru), Titane (Ti), Nickel (Ni).

Pour mettre en œuvre un test d'un circuit électronique 50 matriciel d'adressage, on dispose, de manière provisoire, la structure 10 comme dans l'exemple de réalisation illustré sur la figure 2. On place ainsi la face 10B de contact de la structure 10 sur et en contact d'un ensemble de plots conducteurs 52₁, 52₂,...,52ₙ du circuit 50 d'adressage. Dans l'exemple particulier illustré où les blocs de matériau piézoélectrique 14 affleurent au niveau de cette face de contact, les blocs de matériau piézoélectrique 14 se trouvent directement en contact avec les plots 52₁, 52₂,...,52ₙ.

Lorsque le pas de répartition des blocs 15 de matériau piézoélectrique 14 est prévu supérieur à celui des plots conducteurs du circuit 50, la mise en place de la structure 10 sur le circuit 50 est réalisée avantageusement sans devoir nécessairement réaliser un alignement. Les plots conducteur 52₁, 52₂ du circuit d'adressage sont connectés ici chacun à un ou plusieurs blocs 15₁, 15₂ (respectivement 15₃, 15₄) de la structure de test.

Le circuit 50 d'adressage sous forme par exemple d'un ASIC peut être configuré pour commander individuellement les pixels afficheurs (non représentés sur cette figure) d'une matrice. Le circuit 50 d'adressage est lui-même doté d'éléments 54₁, 54₂ de commande ou d'activation. Les éléments de commande d'un circuit d'adressage sont typiquement dotées chacune d'un ou plusieurs composants électroniques, par exemple d'au moins un transistor. Les éléments de commande ou d'activation que l'on souhaite pouvoir tester et de préférence tester individuellement, sont ici chacune dotée ou reliée à un plot conducteur 52₁, 52₂,...,52ₙ. Chaque plot conducteur 52₁, 52₂,...,52ₙ est ici destiné à être assemblé ou connecté à un pixel de la matrice ou à au moins une couche par exemple une couche d'affichage que dans les deux cas l'on prévoit de rapporter ultérieurement sur le circuit d'adressage.

Les plots conducteurs 52₁, 52₂,...,52ₙ ont ainsi, comme les éléments 54₁, 54₂ de commande et/ou d'activation, également un agencement matriciel en une ou plusieurs rangées de plots 52₁, 52₂,...,52ₙ.

Comme indiqué précédemment, le circuit 50 d'adressage, est ici testé sans la matrice d'afficheurs ou sans la couche d'affichage qu'il est amené à commander et avec laquelle il est destiné à être assemblé. Ainsi, dans un exemple de réalisation particulier où le circuit d'adressage 50 permet de commander un dispositif d'affichage de type micro-écran formé d'une matrice d'éléments d'affichage de type à cristaux liquides ou de LED organique ou de LED à base de matériau semi-conducteur III-V, on vérifie dans la fonctionnalité des éléments 54₁, 54₂...,54ₙ de commande ou d'activation des éléments d'affichage, sans que la matrice d'éléments d'affichage du micro écran ne soit encore assemblée.

Pour pouvoir appliquer des signaux électriques de test aux blocs, on prévoit un agencement avec, d'un premier côté de l'ensemble de blocs 15 de matériau piézoélectrique 14, une électrode 18 commune appartenant à la structure 10 et d'un deuxième côté opposé au premier côté de l'ensemble de blocs 15 de matériau piézoélectrique 14, des plots conducteurs 52₁, 52₂,...,52ₙ d'adressage du circuit de commande à caractériser. Ces plots conducteurs 52₁, 52₂,...,52ₙ forment autant d'électrodes individuelles qui peuvent être commandées indépendamment l'une de l'autre.

Pour vérifier la fonctionnalité individuelle d'un élément de commande 54₁ du circuit électronique 50, on peut lui appliquer en entrée un signal électrique, typiquement une tension, par exemple de l'ordre de plusieurs volts. Lorsque cet élément de commande (ou d'activation) est fonctionnel cela peut se traduire en sortie de cet élément de commande 54₁ relié à un plot conducteur 52₁, par une tension entre une première électrode formée par ce plot conducteur 52₁ et une deuxième électrode 18 correspondant à l'électrode commune. Les signaux de test en particulier sous forme de tensions peuvent être appliqués par exemple via un circuit 55 générateur de signaux électriques de test. Un tel circuit 55 est représenté de manière schématique dans l'exemple de réalisation illustré sur la figure 3.

On détecte alors une déformation de blocs 15₁, 15₂ de matériau piézoélectrique 14 agencés entre cette première électrode 52₁ et cette deuxième électrode 18. Typiquement, lorsqu'un élément de commande et/ou d'activation est dysfonctionnel, le plot conducteur 52₁ de l'élément de commande n'est pas polarisé ou bien est mis à un potentiel différent et aucune déformation ou une déformation moindre des blocs 15₁, 15₂ de matériau piézoélectrique 14 agencés entre cette première électrode 52₁ et cette deuxième électrode 18 est détectée.

Comme évoqué précédemment, une manière de détecter une déformation localisée de blocs 15 de matériau piézoélectrique 14 est d'utiliser un dispositif muni d'un profilomètre, en particulier un profilomètre sans contact, par exemple un interféromètre optique 70 tel qu'illustré sur la figure 3.

L'interféromètre 70 est ici placé du côté d'une face 10A de la structure 10 opposée à la face de contact 10B placée contre le circuit 50 d'adressage. Un tel interféromètre 70 permet d'obtenir une cartographie de déformation des blocs 15 de la structure 10 traduisant une cartographie de fonctionnement des cellules de commande 54₁,...54ₙ ou d'activation du circuit 50 d'adressage. Ainsi, en réalisant une comparaison d'imagerie de déformation de la structure 10 avant et après polarisation de plots conducteurs, on peut définir des zones fonctionnelles ou non de cellules 54₁,..., 54ₙ du circuit 50 d'adressage.

Un contrôle individuel des éléments 54₁,..., 54ₙ du circuit 50 d'adressage, peut être obtenu et se traduire par une polarisation donnée individuelle de chacun des plots conducteurs 52₁, 52₂, ..., 52ₙ.

Par le biais du circuit 55 générateur de signaux de test, on peut appliquer un premier potentiel de test, par exemple d'un ou plusieurs volts, à un premier élément 54₁ de commande doté d'un plot conducteur 52₁ en contact avec un ou plusieurs premiers blocs 15₁, 15₂ de matériau piézoélectrique 14 puis un deuxième potentiel à ce premier élément 54₁. De par l'effet piézoélectrique inverse, ces polarisations différentes impliquent des déformations différentes du piézoélectrique 14. Ces déformations différentes sont mesurées dans cet exemple par l'interféromètre70.

On peut également appliquer un potentiel de test, égal ou différent du premier potentiel de test à un deuxième élément de commande doté d'un deuxième plot conducteur 52₂ en contact avec un ou plusieurs deuxièmes blocs 15₃, 15₄ piézoélectriques.

Les déformations de structure 10, induites par de tels signaux électriques de test peuvent être également détectées à l'aide d'autres moyens de détection.

Par exemple, comme indiqué précédemment, des moyens de détection optiques munis d'une caméra opérant dans le domaine du visible et/ou de l'infrarouge peuvent être également utilisés. Une technique d'observation de la structure 10 au moyen d'une caméra infrarouge est en particulier adaptée à un matériau des blocs 15 de type pyroélectrique, par exemple à base d'AIN ou de ZnO. Une détection dans laquelle on observe au moyen d'une caméra opérant dans le domaine du visible, les coordonnées x,y dans le plan de l'optique de la caméra du signal réfléchi d'un faisceau laser incident émis sur la structure 10 peut être également prévue.

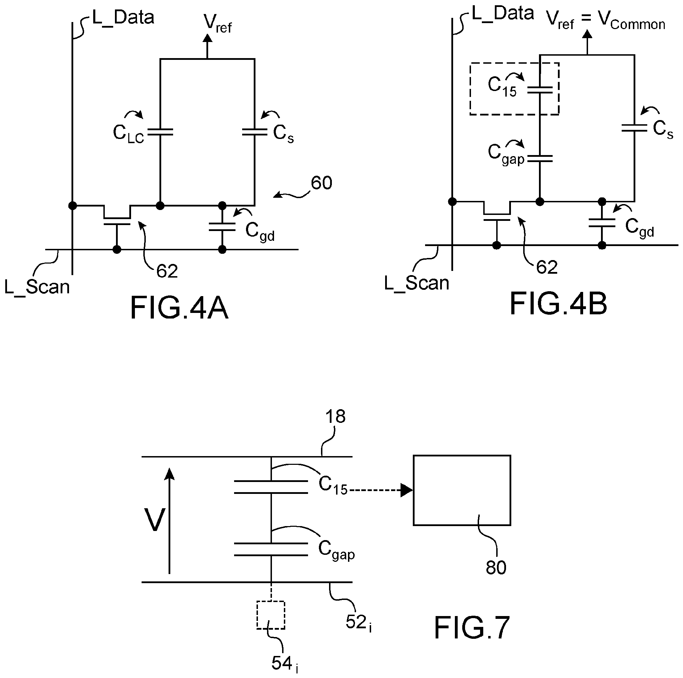

Un schéma électrique équivalent d'un élément de commande 60 de circuit d'adressage est donné à, titre d'exemple sur la figure 4A, dans le cas particulier de l'adressage d'un pixel d'un micro-écran LCD.

L'élément de commande 60 est ici un circuit doté d'un transistor 62 typiquement en technologie TFT (pour « Thin-film transistor ») relié à des lignes d'adressage L_Scan, L_Data partagées par d'autres éléments de commande de l'agencement matriciel du circuit d'adressage, une première ligne d'adressage L_Scan servant par exemple de ligne commune aux éléments de commande d'une même rangée horizontale, tandis qu'une deuxième ligne d'adressage L_Data étant par exemple une ligne commune à des éléments de commande d'une même rangée verticale. On applique à un pixel une tension d'une valeur donnée par le biais de la ligne L_Data lorsque le transistor 62 est activé au moyen d'un signal appliqué sur la ligne L_Scan.

La capacité C_{LC}, correspond à la capacité d'un élément d'affichage à cristaux liquides, Cgd, représentant quant à elle une capacité parasite et Cs correspond à la capacité de stockage de la tension pendant le changement d'une trame. Les capacités C_{LC}, Cₛ ont une borne mise à un potentiel de référence.

Lorsqu'on introduit une structure 10 de test telle que mise en œuvre suivant l'invention et décrite précédemment, un schéma équivalent d'un élément de commande associé à cette structure 10 est modifié comme sur la figure 4B.

La capacité C_{LC} est alors remplacée par des capacités en séries C₁₅, Cgap. C₁₅, Cgap représentent respectivement : la capacité des blocs 15 qui sont connectés à la cellule de commande testée, et une capacité parasite de l'air susceptible de rester entre une face 50A de l'ASIC sur laquelle affleurent les plots 52₁, 52₂, ..., 52ₙ et la face de contact 10B de la structure 10 de test sur laquelle affleurent les blocs de matériau piézoélectrique. Le potentiel de référence V_{ref} est égal ici à celui V_{common} de l'électrode 18 commune de la structure de test 10.

La capacité d'un ou plusieurs blocs 15₁ donnés de la structure peut varier en fonction des potentiels appliqués au niveau des électrodes 18, 52₁ situées de part et d'autre de ce bloc donné 15₁. Ainsi, en complément ou en variante d'une mesure de déformation de la structure 10, il est également possible de réaliser une ou plusieurs mesures capacitives entre au moins un plot conducteur 52₁, 52₂,...,52ₙ d'adressage et l'électrode 18 commune, et ce pour différentes tensions.

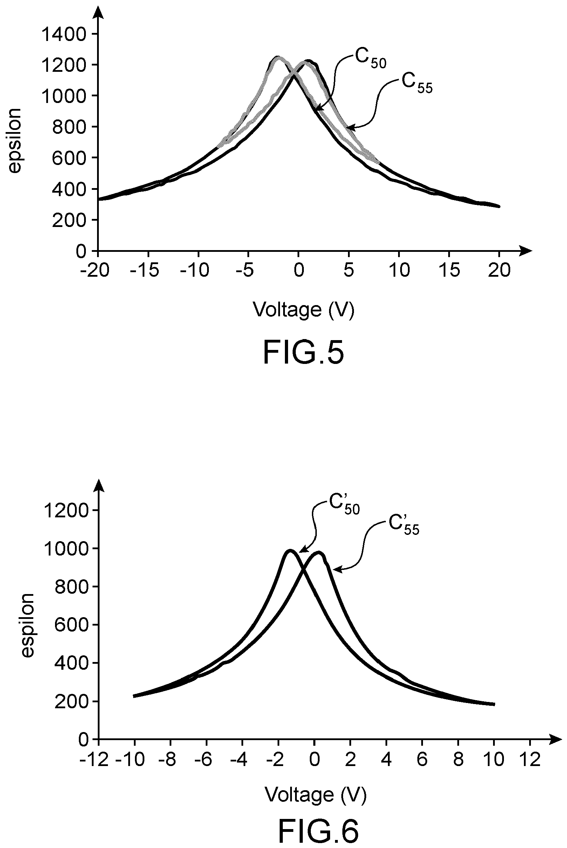

Par exemple, comme on peut le voir à partir des courbes C₅₀ et C₅₅ de la figure 5, servant à illustrer un résultat issu de données expérimentales, la variation de capacité pour un bloc 15 de matériau PZT d'une épaisseur de l'ordre de 0.5 µm peut varier de l'ordre de 30% à 40% entre l'application d'une première tension de 0V et d'une seconde tension de l'ordre de 5V.

L'épaisseur de matériau 14 choisie dans la structure peut influer sur cette variation comme cela est montré par l'exemple illustré sur la figure 6. Les courbes C'₅₀ et C'₅₅ montrent ainsi que pour une couche de même composition, ici en PZT, mais d'épaisseur plus fine, ici de l'ordre de 0.15 µm, peut dans les mêmes conditions, entre une tension appliquée de 0V et une tension appliquée de 5V, conduire à une variation de capacité de l'ordre de 70%.

Ainsi, les éléments de commande ou sous-cellules 54₁,...54ₙ d'un circuit d'adressage matriciel peuvent être également caractérisées en détectant une variation de valeur de capacité de blocs 15 de matériau diélectrique dont les propriétés diélectriques sont modulées en fonction de l'intensité d'un champ électrique qui leur est appliquée.

Ici, un champ électrique est typiquement appliqué sous forme d'une tension V entre un plot conducteur 52ᵢ et l'électrode commune 18, cette tension V dépendant elle-même d'une tension ou d'un potentiel de test appliqué à une cellule de commande 54ᵢ reliée ou doté de ce plot conducteur 52ᵢ.

Dans l'exemple de réalisation illustré sur la figure 7, on fait varier la tension V appliquée entre le plot conducteur 52i d'une sous-cellule 54i donnée et on mesure, par exemple à l'aide d'un capacimètre 80, une variation de capacité C₁₅ d'une portion de matériau diélectrique, en fonction de cette variation.

Ainsi, la détection ou mesure effectuée à l'aide d'une structure telle que décrite précédemment peut, en variante ou en combinaison d'un dispositif optique, être réalisée à l'aide de moyens de mesure électriques. Dans le cas où les blocs sont en matériau ferroélectrique, on peut par exemple mesurer une variation de courant dipolaire traversant les blocs 15 de matériau ferroélectrique et résultant d'une variation de champ électrique de test appliqué sur ces blocs.

De même, selon une variante de réalisation des exemples donnés précédemment, on peut également prévoir une structure de test pour laquelle les blocs 15, aux extrémités desquelles on applique une tension de test, sont en un matériau diélectrique, non nécessairement piézoélectrique, mais dont les propriétés diélectriques sont modulables en fonction de l'amplitude d'un champ électrique qui lui est appliqué. Un tel matériau peut être par exemple du BaₓSr(₁₋ₓ)TiO₃ connu sous l'acronyme BST, ou du BCTZ (Ba(Ti_{X}Zr_{1-X})O₃-(Ba_{Y}Ca_{1-Y})TiO₃) (BCTZ).

En ce qui concerne le circuit permettant de générer les signaux de tests évoqué précédemment, celui-ci peut être pourvu d'au moins un étage ou bloc de test intégré au circuit d'adressage ou dans un même composant ou sur une même puce que ce circuit d'adressage.

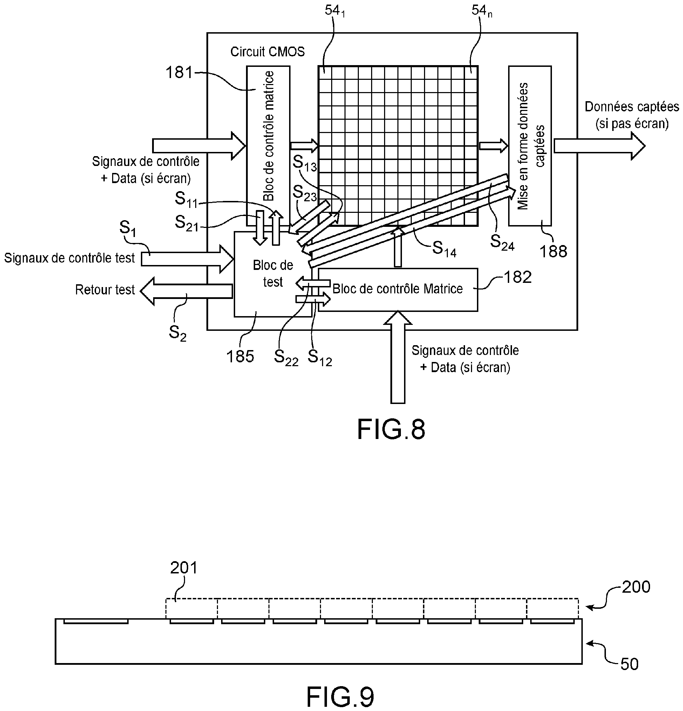

Ainsi, dans l'exemple de réalisation illustré sur la figure 8, le circuit d'adressage, par exemple réalisé en technologie CMOS, est formé d'un agencement matriciel d'éléments de commande 54₁,...,54ₙ piloté par le biais de blocs 181, 182 de contrôle et intègre un bloc 185 de test configuré pour émettre des signaux de test à destination des blocs 181, 182 de contrôle. De tels blocs 181, 182 permettent en particulier de contrôler respectivement l'adressage de rangées horizontales et de rangées verticales d'éléments 54 de commande.

Le bloc de test 185 peut lui-même recevoir des signaux S₁ de contrôle de test provenant d'un circuit extérieur, par exemple un circuit logique. De tels signaux S₁ permettent notamment de déclencher et/ou paramétrer une émission de signaux S₁₁, S₁₂ de test que le bloc de test 185 émet à destination des blocs 181, 182 de contrôle. Le bloc de test 185 peut être également configuré pour émettre des signaux S₂ de retour, notamment d'acquittement indiquant la fin de test ou d'une phase de mesure. Les signaux produits par le bloc 185 peuvent être de type analogique ou numérique, et de préférence compatibles avec des blocs internes à tester et avec un environnement de test externe. Ce dernier peut par exemple utiliser un protocole type JTAG pour (« Joint Test Action Group » ou Groupe d'action de test conjoint) suivant la norme IEEE 1149.1.

Une émission de signaux S₁₃ du bloc de test directement aux éléments de commande peut être également mise en oeuvre.

Dans un cas particulier notamment où le circuit d'adressage est dédié à la commande d'un autre type de cellules que des pixels d'affichage, par exemple des cellules faites d'éléments de détection ou capteurs, le bloc de test 185 peut être également configuré pour échanger des signaux S₁₄, S₂₄, avec un étage 188 de mise en forme de données captées par ces pixels.

Ainsi, une structure de test 10 telle que décrite précédemment et un dispositif de test tel que décrit précédemment ne sont pas limitées à la mise en œuvre de test(s) et/ou de mesure(s) sur un circuit d'adressage dédié à la commande d'une matrice d'éléments afficheurs.

Il est ainsi également possible d'utiliser une telle structure 10 de test et de mettre en œuvre un dispositif de test pour vérifier la fonctionnalité de circuits d'adressage dédiés à la commande de matrices ayant des cellules de type différents.

On peut ainsi appliquer la structure et le dispositif de test à un circuit d'adressage de cellules dotées chacune d'un élément détecteur, par exemple de rayonnement électromagnétique et/ou d'un élément capteur, par exemple de type MEMS et/ou d'un élément transducteur, par exemple électro-acoustique ou électromécanique et/ou d'un élément émetteur, par exemple d'ondes électromagnétiques ou acoustiques et/ou d'un élément actionneur, par exemple de type MEMS.

Ainsi, selon des exemples de réalisation particuliers, on peut effectuer des tests sur un circuit d'adressage d'une matrice de capteurs d'images par rayons X, ou infrarouge, voire de pixels d'un imageur térahertz. On peut en particulier utiliser une telle structure 10 pour vérifier la fonctionnalité du circuit d'adressage d'un détecteur matriciel à base de micro-bolomètres couplés à des antennes.

Selon un autre exemple de réalisation particulier, il est également possible de réaliser un test de fonctionnalité d'un circuit d'adressage permettant de commander une matrice de composants de type MEMS (« Microelectromechanical systems ») ou NEMS (« Nanoelectromechanical systems »), en particulier d'une matrice de composants MEMS ou NEMS utilisés par exemple pour effectuer des mesures de masse moléculaire, ou de détection de gaz. Un autre exemple prévoit le test d'une matrice d'accéléromètres et/ou de gyromètres en technologie MEMS.

Selon un autre exemple, on peut tester une matrice d'éléments actionneurs de micro-miroirs, en particulier des miroirs orientables d'un dispositif DLP (pour « Digital Light Processing », i.e. « traitement numérique de la lumière »).

Une structure de test 10 telle que décrite précédemment et un dispositif de test utilisant une telle structure ne sont pas non plus nécessairement limités à la mise en œuvre d'un test de fonctionnalité dans lequel on vient vérifier si une cellule de commande et/ou d'activation d'un circuit matriciel est ou non fonctionnelle. Outre des tests de débogage, on peut également mettre en œuvre des tests et/ou mesures visant à caractériser et/ou régler le fonctionnement des cellules de commande du circuit d'adressage.

Un exemple de méthodologie afin de réaliser une mesure ou un test sur un circuit d'adressage par exemple sous forme d'un ASIC peut être le suivant.

Avantageusement, on effectue tout d'abord un nettoyage de la surface de l'ASIC sur laquelle, les plots conducteurs sont situés.

On dispose ensuite la structure de test sur les plots conducteurs de la matrice de l'ASIC, sans nécessairement devoir réaliser un alignement.

On connecte ensuite le circuit générateur de signaux de test notamment aux plots conducteurs servant à adresser l'ASIC et à l'électrode commune de la structure de test.

Puis, on effectue une mesure sur la structure à l'aide d'un dispositif optique, par exemple à l'interféromètre plein champs, sans mettre en œuvre une polarisation de l'électrode commune et du ou des plots conducteurs de l'ASIC.

On effectue ensuite une ou plusieurs mesures en émettant un ou plusieurs signaux électriques de test, autrement dit en réalisant une polarisation de l'électrode commune et du ou des plots conducteurs de l'ASIC.

Une ou plusieurs mesure(s) capacitive(s) entre plot(s) d'adressage et l'électrode commune peuvent être tout d'abord effectuées.

Puis, une ou plusieurs mesure(s) peuvent être réalisées.

On peut détecter alors des zones de défauts en comparant la forme de la structure avec sa forme initiale obtenue sans polarisation.

On peut également effectuer des mesures pour différents niveaux de tensions de polarisation.

Pour chaque niveau de tension de polarisation on peut alors effectuer une mesure électrique, par exemple de capacité. On peut également effectuer une mesure de déformation, par exemple par mesure optique.

Comme indiqué précédemment une structure de test et un dispositif de test tels que décrits plus haut peuvent être utilisés lors du procédé de fabrication d'un dispositif matriciel doté d'une matrice d'élément, afficheurs ou détecteurs, ou capteurs, ou, transducteurs et commandés chacun par le biais d'une cellule de commande d'un circuit électronique d'adressage. Dans ce cas, on met en place le dispositif de test afin de tester le circuit d'adressage avant que ce circuit d'adressage ne soit assemblé et connecté avec la matrice de pixels ou avec une couche permettant de finaliser la fabrication de cette matrice. La figure 9 sert à illustrer un exemple d'assemblage final d'une matrice 200 de pixels 201 sur le circuit d'adressage 50 une fois qu'un test tel que décrit précédemment a été réalisé.

Un test de production au cours du procédé de fabrication d'un dispositif matriciel peut être ainsi réalisé à l'aide d'une structure décrite précédemment. Ainsi, on peut tester fonctionnellement le circuit d'adressage par exemple en technologie CMOS et fabriqué chez un fondeur X. Le test peut être avantageusement réalisé sur une plaque (« wafer » selon la technologie anglo-saxonne ») sur laquelle plusieurs circuits d'adressage du même type sont réalisés. Puis, un fabricant Y réceptionnant ce circuit d'adressage peut, suite au test effectué sur le circuit d'adressage, effectuer soit le report, soit le dépôt de la couche émettrice ou réceptrice ou d'une couche apte à modifier un rayonnement électromagnétique incident. Le fabricant Y connait alors l'ensemble des puces CMOS qui sont ou non acceptables, ce qui lui permet de gagner du temps lors des étapes de fabrication et surtout de vérification fonctionnelle qui suivent généralement l'assemblage de la matrice et du circuit d'adressage matriciel.

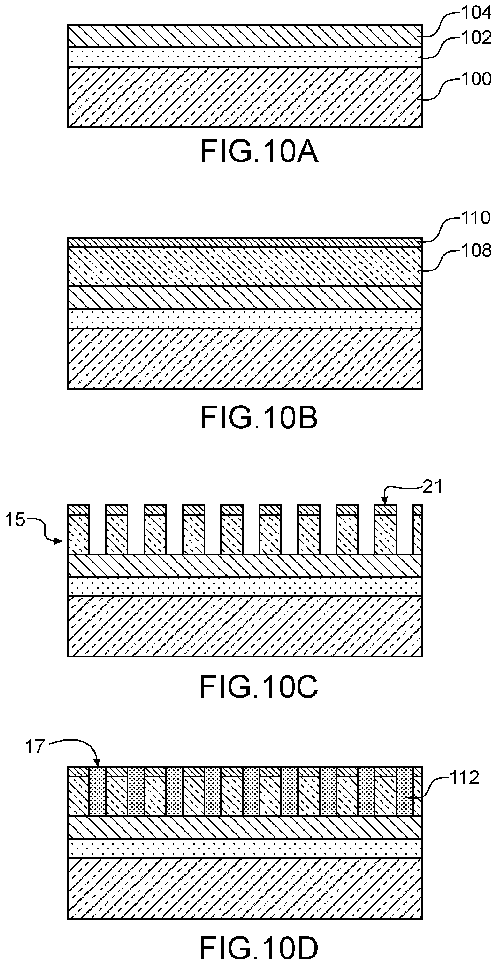

Un exemple de procédé de fabrication d'une structure de test telle que décrite précédemment et en particulier en liaison avec la figure 1, va à présent être donné en liaison avec les figures 10A-10H.

Un matériau de départ pour ce procédé peut être un substrat 100 appelé « donneur» ou encore « sacrificiel ». Ce substrat 100 donneur est typiquement semi-conducteur et par exemple à base de silicium. Le substrat 100 peut être prévu avec une épaisseur comprise par exemple entre 100 µm et 1 mm.

Le substrat 100 est revêtu (figure 10A) d'une première couche 102 dite « de séparation », d'épaisseur qui peut être comprise par exemple entre 1 nm et 20 µm, et d'une deuxième couche 104 de séparation, d'épaisseur comprise par exemple entre 1 nm et 200 nm sur la première couche de séparation 102.

La couche première couche de séparation 102 peut être par exemple à base d'oxyde de silicium et/ou de nitrure de silicium tandis que la deuxième couche de séparation 104 peut être à base d'un métal noble tel que par exemple de l'argent (Ag) ou de l'or (Au) ou du platine (Pt).

Les matériaux respectifs des couches de séparation 102, 104 sont choisis de sorte à réaliser une interface de faible force d'adhérence entre ces deux couches 102, 104 de séparation. Par exemple, on réalise une interface formée d'une couche 104 en platine sur une couche 102 en oxyde de silicium. Cette dernière peut être réalisée par exemple par oxydation thermique du substrat 100.

On forme ensuite les blocs 15 répartis selon un agencement matriciel.

Dans l'exemple de réalisation particulier illustré sur la figure 10B, les blocs 15 sont réalisés dans une couche 108 de matériau piézoélectrique. Le matériau piézoélectrique peut être exemple un ferroélectrique tel que du titano-zirconate de plomb (PZT), ou du PZT dopé au Lanthane (La) ou au Niobium (Nb), ou du PMN-PT (niobate-titanate de plomb-magnésium), ou du KNN (Sodium Niobate de Potassium), ou du BNT, ou bien du BNT-BT. Le matériau piézoélectrique peut être également un pyroélectrique tel que de l'AIN ou du ZnO.

La couche 108 peut avoir une épaisseur comprise entre plusieurs dizaines de nanomètres et plusieurs micromètres, par exemple entre 50 nm et 1 micromètre.

On peut réaliser ensuite une couche réfléchissante 110 sur la couche 108 de matériau piézoélectrique. Cette couche réfléchissante 110 typiquement métallique peut être réalisée par exemple à base de l'un des métaux suivants Pt, Ru, Ti, Ni, Au avec une épaisseur qui peut être comprise par exemple entre 5 nm et 500 nm.

Les couches 108, 110 sont ensuite structurées (figure 10C) afin de définir des blocs distincts 15 de matériau piézoélectrique répartis selon un agencement matriciel et des zones réflectrices 21 sur chacun de ces blocs 15. Une telle étape peut être réalisée par exemple par photolithographie afin de définir un masquage puis de gravure à travers des ouvertures de ce masquage.

On peut ensuite réaliser un remplissage inter-blocs afin de former les régions de séparation 17. Typiquement le matériau 112 utilisé pour le remplissage inter-blocs est isolant. Le matériau de remplissage utilisé de préférence prévu avec un faible module d'Young, est typiquement en polymère. Le matériau 112 peut par exemple une résine photosensible telle que celle référencée WBR2050 fabriquée par la société Dupont^{™}, ou bien un polymère de passivation par exemple de type LTC 90xx, ou TOK TELR.

Après remplissage, on réalise une planarisation soit par photo-définition soit par CMP (polissage mécano-chimique) afin d'ôter tout dépôt de matériau de séparation sur les zones 21 (figure 10D).

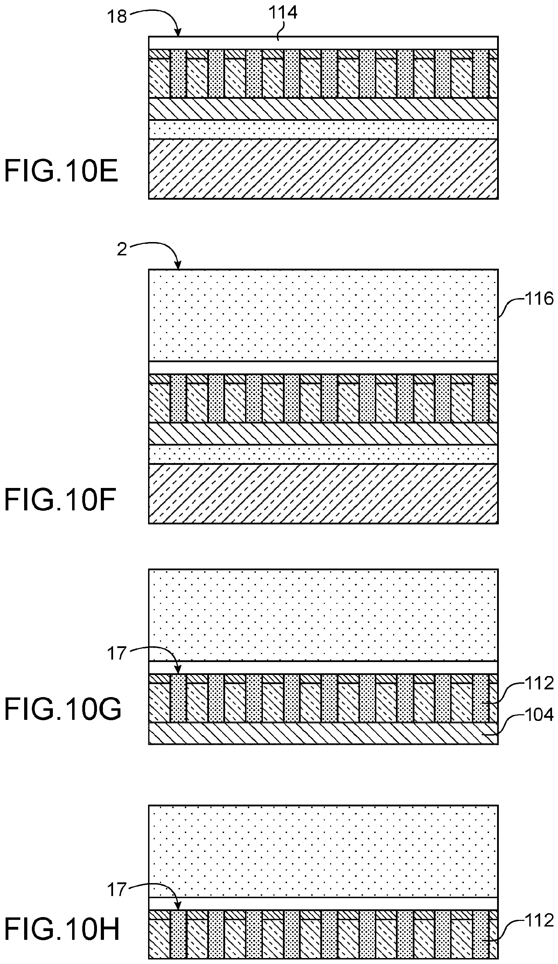

Pour former l'électrode 18 commune, on dépose ensuite (figure 10E) une couche conductrice 114, ici transparente et qui peut être à base d'un oxyde conducteur transparent (TCO), par exemple à base d'ITO et d'épaisseur par exemple comprise par exemple entre 1 nm et 500 nm.

On peut ensuite (figure 10F) déposer une couche 116 de support, par exemple en polymère ou en verre, afin de former le substrat 2, de préférence un substrat souple.

Puis, on effectue une séparation du substrat donneur en effectuant une fracturation entre les couches 102, 104 de séparation (figure 10G). Cela peut être réalisé par exemple en introduisant une lame entre les deux couches 102, 104.

On retire ensuite (figure 10H) la deuxième couche 104 de séparation par exemple par gravure à l'aide de solution chimique tel qu'un mélange HCl/HNO₃.

## Revendications

1. Structure (10) pour le test d'un circuit électronique (50) d'adressage d'une matrice de cellules, ledit circuit électronique d'adressage (50) étant destiné à être assemblé avec et connecté à ladite matrice ou au moins une couche de ladite matrice par l'intermédiaire de plots conducteurs (52₁, 52₂,..., 52ₙ), ladite structure (10) comprenant :
- une pluralité de blocs (15₁,...,15ₘ) à base d'au moins un premier matériau (14), piézo-électrique et/ou diélectrique dont les propriétés diélectriques sont modulables en fonction de l'intensité d'un champ électrique qui lui est appliqué, lesdits blocs ayant une première extrémité et une deuxième extrémité, la deuxième extrémité étant opposée à la première extrémité et aboutissant au niveau d'une face (10B) de contact de ladite structure ou d'une zone conductrice aboutissant au niveau de ladite face (10B) de contact, la deuxième extrémité (15B) desdits blocs (15₁,...,15ₘ) étant apte à être connectée à au moins un plot conducteur donné parmi un ensemble de plots conducteurs d'un circuit électronique d'adressage,
- au moins une région de séparation (17) entre lesdits blocs (15), ladite au moins une région de séparation (17) étant à base d'au moins un matériau (16) isolant, ladite structure (10) de test comprenant en outre :
- une électrode (18) commune connectée à la première extrémité (15A) desdits blocs (15₁,...,15ₘ) à base dudit premier matériau (14).

2. Structure selon la revendication 1, dans laquelle l'électrode commune (18) repose sur un substrat (2), avec un rapport densité volumique de masse sur module d'Young (d/E) supérieur à 100 s²m⁻², en particulier en matériau polymère ou en caoutchouc.

3. Structure selon l'une des revendications 1 ou 2, dans laquelle l'électrode commune (18) repose sur un substrat (2) à base de matériau transparent.

4. Structure selon l'une des revendications 1 à 3, dans lequel l'électrode commune (18) est formée d'une couche conductrice transparente (19).

5. Structure selon l'une des revendications 1 à 4, dans lequel ladite première extrémité desdits blocs (15) à base dudit premier matériau (14) est revêtue d'une zone conductrice (21) et réfléchissante.

6. Structure selon l'une des revendications 1 à 5, dans lequel ledit matériau isolant (16) est à base de matériau polymère et/ou a un module d'Young inférieur à 100 GPa, avantageusement inférieur à 50 GPa.

7. Dispositif de test pour circuit électronique (50) d'adressage d'une matrice de cellules, comprenant :
- le circuit électronique d'adressage (50), chaque cellule étant apte à être commandée par le biais d'un élément de commande dudit circuit électronique d'adressage (50), ledit circuit électronique d'adressage (50) étant doté d'un ensemble matriciel d'éléments (54₁, 54₂,..., 54ₙ) de commande et ayant un agencement matriciel de plots conducteurs (52₁, 52₂,..., 52ₙ), chaque élément de commande étant pourvu d'au moins un desdits plot conducteurs, le dispositif de test comprenant en outre :
- une structure (10) selon l'une des revendications précédentes, ladite structure (10) étant agencée de manière amovible sur ledit circuit d'adressage (50) et de sorte qu'au moins un premier plot conducteur (52₁) parmi lesdits plots conducteurs est connecté à un ou plusieurs blocs (15₁, 15₂) à base du premier matériau (14) de ladite structure, et qu'au moins un deuxième plot conducteur (52₂) parmi lesdits plots conducteurs est connecté à un ou plusieurs autres blocs (153, 15₂) à base du premier matériau de ladite structure (10).

8. Dispositif de test selon la revendication 7, dans lequel dans ledit ensemble matriciel, lesdits plots conducteurs du circuit d'adressage (50) sont répartis selon un premier pas de répartition et dans lequel les blocs à base dudit premier matériau sont répartis selon un autre ensemble matriciel avec un deuxième pas de répartition, le deuxième pas de répartition étant prévu supérieur au premier pas de répartition et de sorte que chaque plot conducteur est connecté à au moins un bloc (15) à base du premier matériau de ladite structure (10).

9. Dispositif de test selon l'une des revendications 7 ou 8, comprenant en outre : un circuit (55) générateur de signaux électriques de test, ledit circuit (55) générateur étant connecté à ladite électrode commune (18) et configuré pour appliquer un ou plusieurs signaux électriques de test auxdits éléments de commande (54₁, 54₂,..., 54ₙ) dudit circuit d'adressage (50).

10. Dispositif de test selon la revendication 9, dans lequel ledit premier matériau (14) est piézoélectrique, comprenant en outre un dispositif de mesure, en particulier doté d'un interféromètre (70) sans-contact et/ou de moyens de mesures optiques munis d'une caméra, le dispositif de mesure étant configuré pour détecter une déformation de ladite structure (10) consécutive à l'application d'au moins un premier signal électrique de test à un premier élément de commande (54₁).

11. Dispositif de test selon l'une des revendications 9 ou 10, comprenant en outre un dispositif de mesure électrique connecté à l'électrode commune (18) et à au moins un premier plot (52₁) parmi lesdits plots conducteurs, le dispositif de mesure électrique étant configuré pour mesurer un signal électrique de réponse à au moins un premier signal électrique de test appliqué à un premier élément de commande (54₁) relié au premier plot (52₁),
le dispositif de mesure électrique étant en particulier doté d'un capacimètre configuré pour, consécutivement à l'application du premier signal électrique de test, mesurer une capacité entre ledit premier plot (52₁) et ladite électrode et/ou d'un moyen de mesure de courant entre ledit premier plot (52₁) et ladite électrode consécutif à l'application du premier signal électrique de test.

12. Dispositif de test selon l'une des revendications 9 à 11, dans lequel ledit circuit (55) générateur de signaux de test est configuré pour :
- appliquer un premier potentiel à un premier élément de commande (54₁) du circuit d'adressage, puis appliquer un autre potentiel différent du premier potentiel au premier élément de commande (54₁), et/ou pour,
- appliquer un premier potentiel à un premier élément de commande (54₁) du circuit d'adressage et appliquer un deuxième potentiel à un deuxième élément de commande (54₂) du circuit d'adressage.

13. Dispositif de test selon l'une des revendications 7 à 12, dans lequel lesdites cellules sont dotées chacune d'un élément afficheur, ou détecteur, ou capteur, ou transducteur, ou émetteur, ou actionneur.

14. Dispositif de test selon l'une des revendications 7 à 13, dans lequel le circuit électronique d'adressage (50) est dédié à la commande d'une matrice de cellules chacune dotée d'un d'élément afficheur LCD ou LED organique ou micro-LED, en particulier en matériau III-N tel que du GaN.

15. Procédé de fabrication d'un dispositif matriciel doté d'une matrice de cellules, chaque cellule étant apte à être commandé par le biais d'un élément de commande d'un circuit électronique d'adressage (50), le procédé comprenant, dans cet ordre, des étapes consistant à :
- mettre en place un dispositif de test selon l'une des revendications 7 à 13, pour tester le circuit d'adressage (50),
- retirer ladite structure (10) de test dudit circuit d'adressage (50), puis
- assembler et connecter ladite matrice de cellules ou au moins une couche, en particulier d'affichage, sur ledit circuit d'adressage (50).
